# EUROPEAN PATENT APPLICATION

(11) **EP 1 286 575 A2**
(43) Date of publication of application: **26.02.2003**
(21) Application number: 02255550.2
(22) Date of filing: 08.08.2002
(51) Int. Cl.: H05K 1/03, H05K 3/46

(54) **Module component, core substrate element assembly, multi-layer substrate, method of manufacturing core substrate element assembly, method of manufacturing multi-layer substrate, and method of manufacturing module component**

(30) Priority: 22.08.2001 JP 2001251663; 03.07.2002 JP 2002194810
(71) Applicant: TDK Corporation, Chuo-ku, Tokyo 103-8272 (JP)
(72) Inventor: Takaya, Minoru, c/o TDK Corporation, Tokyo 103-8272 (JP); Endo, Toshikazu, c/o TDK Corporation, Tokyo 103-8272 (JP)
(74) Representative: Dealtry, Brian

(57) **Abstract**

The present invention relates to a module component for which degradation of electrical properties caused by absorption of moisture in the air can be prevented. An intermediate layer (70) comprises a first layer (20), a second layer (30) and a core layer (10). The core layer (10) comprises a material having a higher strength than the first layer (20) and the second layer (30), has a network structure that extends out in planar fashion, has an outer periphery (11) thereof positioned further to the inside than the outer peripheries of the first layer (20) and the second layer (30), and is sealed between the first layer (20) and the second layer (30). An upper layer (71) is laminated on the upper surface of the intermediate layer (70). A lower layer (72) is laminated on the lower surface of the intermediate layer (70). Mounted components (74) are mounted on any one of the upper layer (71) and the lower layer (72).

## Description

### BACKGROUND OF THE INVENTION

### 1. Field of the Invention

The present invention relates to a module component, a core substrate element assembly, a multi-layer substrate, a method of manufacturing a core substrate element assembly, a method of manufacturing a multi-layer substrate, and a method of manufacturinga module component

### 2. Description of the Related Art

There are demands for the substrate strength and the electrical properties of multi-layer substrates for circuits used in communications applications, consumer applications, industrial applications and the like to be improved. For example, with the multi-layer substrate disclosed in Japanese Patent Publication No. 1996-139424A, glass cloth is used in a core layer of the multi-layer substrate to improve the substrate strength.

The multi-layer substrate disclosed in Japanese Patent Publication No. 1996-139424A is manufactured by first preparing a glass cloth formed by weaving a large number of glass fiber bundles in a lattice shape, and a work sheet comprising this glass cloth impregnated with a synthetic resin, and then dividing this work sheet in a direction intersecting the glass fiber bundles to form individual pieces. Because the multi-layer substrate is manufactured by dividing the work sheet in a direction intersecting the glass fiber bundles, the resulting structure is such that the cut surfaces of the glass cloth and the synthetic resin are exposed at the sides of the multi-layer substrate.

The adhesiveness of the glass cloth to the synthetic resin is low. Hence, in the structure in which the cut surfaces of the glass cloth and the synthetic resin are exposed at the sides of the multi-layer substrate as in Japanese Patent Publication No. 1996-139424A, there is a problem that moisture in the air is absorbed into the multi-layer substrate from the interfaces between the glass cloth and the synthetic resin, resulting in a degradation of electrical properties such as insulation.

Moreover, the glass cloth has a structure in which a large number of glass fibers are bundled together, and hence there are cavities between the glass fibers in a number corresponding to the number of glass fibers. There are thus a large number of cavities at the cut surfaces of the glass cloth, and hence there is a problem that a large amount of moisture in the air is absorbed into the multi-layer substrate from these cavities, resulting in a marked degradation of electrical properties such as insulation.

### SUMMARY OF THE INVENTION

It is an object of the present invention to provide a module component having high substrate strength.

It is another object of the present invention to provide a module component for which degradation of electrical properties caused by absorption of moisture in the air can be prevented.

It is another object of the present invention to provide a core substrate element assembly suitable for manufacturing a module component as described above.

It is another object of the present invention to provide a multi-layer substrate suitable for manufacturing a module component as described above.

It is another object of the present invention to provide a manufacturing method suitable for manufacturing a core substrate element assembly as described above.

It is another object of the present invention to provide a manufacturing methodsuitable for manufacturinga multi-layer substrate as described above.

It is another object of the present invention to provide a manufacturing method suitable for manufacturing a module component as described above.

In order to achieve the objects described above, the module component according to the present invention comprises an intermediate layer, an upper layer, a lower layer and a mounted component.

The intermediate layer comprises a first layer, a second layer, and a core layer.

The core layer comprises a material having a higher strength than the first layer and the second layer, has a network structure that extends out in planar fashion, has an outer periphery thereof positioned further to the inside than the outer peripheries of the first layer and the second layer, and is sealed between the first layer and the second layer.

The upper layer is laminated on an upper surface of the intermediate layer. The lower layer is laminated on a lower surface of the intermediate layer. The mounted component is mounted on any one of the upper layer and the lower layer.

In the module component according to the present invention, the core layer comprises a material having a higher strength than the first layer and the second layer, and extends out in planar fashion. As a result, the strength in a direction orthogonal to the principal plane ofthe core layer is increased.

Moreover, in the module component according to the present invention, the core layer is sealed between the first layer and the second layer, and hence the first layer, the second layer and the core layer are integrated into a single body. As a result, the module component according to the present invention has increased strength in the direction orthogonal to the principal plane of the core layer. Accordingly, the strength required of the intermediate layer of the module component can be secured.

In the module component according to the present invention, the outer periphery of the core layer is positioned further to the inside than the outer peripheries of the first layer and the second layer. As a result, by selecting resin materials for the first layer and the second layer having high adhesiveness to one another, and placing thefirst layer and the second layer on top of one another with the core layer there between, the core layer can be sealed reliably.

Moreover, the core layer has a network structure, and hence the first layer and the second layer are bonded together via the gaps in the network structure. As a result, by selecting resin materials for the first layer and the second layer having high adhesiveness to one another, the strength of bonding between the first layer, the second layer and the core layer can be increased. Moreover, because the core layer has a network structure, it is possible to form through holes avoiding thecore layer.

Moreover, in the module component according to the present invention, the core layer is sealed between the first layer and the second layer, and hence is not exposed to the outside. As a result, even if the adhesiveness of the first layer and the second layer to the core layer is low, there will be no absorption of moisture in the air from the interfaces of the core layer, and hence degradation of the electrical properties of the circuit elements of the module component can be prevented.

Moreover, in the module component according to the present invention, the upper layer is laminated on the upper surface of the intermediate layer, and the lower layer is laminated on the lower surface of the intermediate layer, and hence the upper layer and the lower layer are integrated into a single body via the intermediate layer. As a result, strength can be secured due to the intermediate layer, and hence even if the upper layer and the lower layer are not strong, the substrate strength of the module component as a whole can be secured.

Moreover, any chosen material can be used for the upper layer and the lower layer, and any chosen circuit elements can be constituted in the upper layer and the lower layer.

Moreover, in the module component according to the present invention, the mounted component is mounted on any one of the upper layer and the lower layer. As a result, circuit elements formed in any one of the intermediate layer, the upper layer and the lower layer are integrated with the mounted component, and hence functions as a module component can be exhibited.

Furthermore, in the present invention, also disclosed are a method of manufacturing a module component as described above, a core substrate element assembly and a multi-layer substrate suitable for manufacturing such a module component, and methods of manufacturingsuch a core substrate element assembly and such a multi-layer substrate.

### BRIEF DESCRIPTION OF THE DRAWINGS

Fig. 1 is a perspective view showing the constitution of a module component according to the present invention;
Fig. 2 is a front view of an intermediate layer contained in the module component shown in Fig. 1;
Fig. 3 is front sectional view of the intermediate layer shown in Fig. 2;
Fig. 4 is an exploded perspective view of the intermediate layer shown in Fig. 2;
Fig. 5 is an exploded perspective view showing the constitution of a core substrate element assembly according to the present invention;
Fig. 6 is a process drawing showing an embodiment of a method of manufacturing the core substrate element assembly according to the present invention;
Fig. 7 is another process drawing showing the embodiment of the method of manufacturing the core substrate element assembly according to the present invention;
Fig. 8 is yet another process drawing showing the embodiment of the method of manufacturing the core substrate element assembly according to the present invention;
Fig. 9 is yet another process drawing showing the embodiment of the method of manufacturing the core substrate element assembly according to the present invention;
Fig. 10 is a plan view showing Fig. 9 in more detail;
Fig. 11 is yet another process drawing showing the embodiment of the method of manufacturing the core substrate element assembly according to the present invention;
Fig. 12 is yet another process drawing showing the embodiment of the method of manufacturing the core substrate element assembly according to the present invention;
Fig. 13 is yet another process drawing showing the embodiment of the method of manufacturing the core substrate element assembly according to the present invention;
Fig. 14 is an exploded perspective view showing the constitution of a multi-layer substrate according to the present invention;
Fig. 15 is a process drawing showing an embodiment of a method of manufacturing the multi-layer substrate according to the present invention;
Fig. 16 is another process drawing showing the embodiment of the method of manufacturing the multi-layer substrate according to the present invention;
Fig. 17 is yet another process drawing showing the embodiment of the method of manufacturing the multi-layer substrate according to the present invention;
Fig. 18 is yet another process drawing showing the embodiment of the method of manufacturing the multi-layer substrate according to the present invention;
Fig. 19 is a process drawing showing an embodiment of a method of manufacturing the module component according to the present invention;
Fig. 20 is another process drawing showing the embodiment of the method of manufacturing the module component according to the present invention;
Fig. 21 is yet another process drawing showing the embodiment of the method of manufacturing the module component according to the present invention; and
Fig. 22 is yet another process drawing showing the embodiment of the method of manufacturing the module component according to the present invention.

### DESCRIPTION OF THE PREFERRED EMBODIMENTS

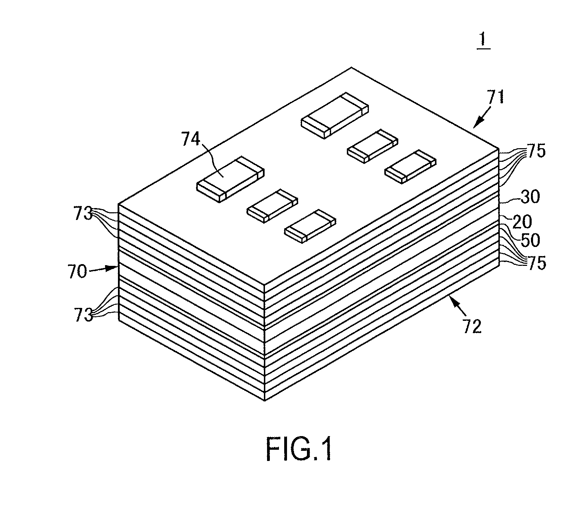

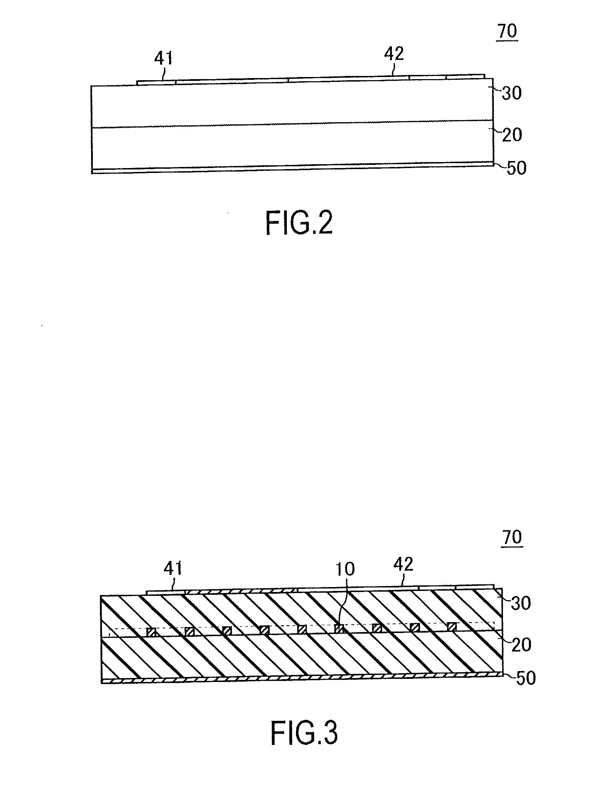

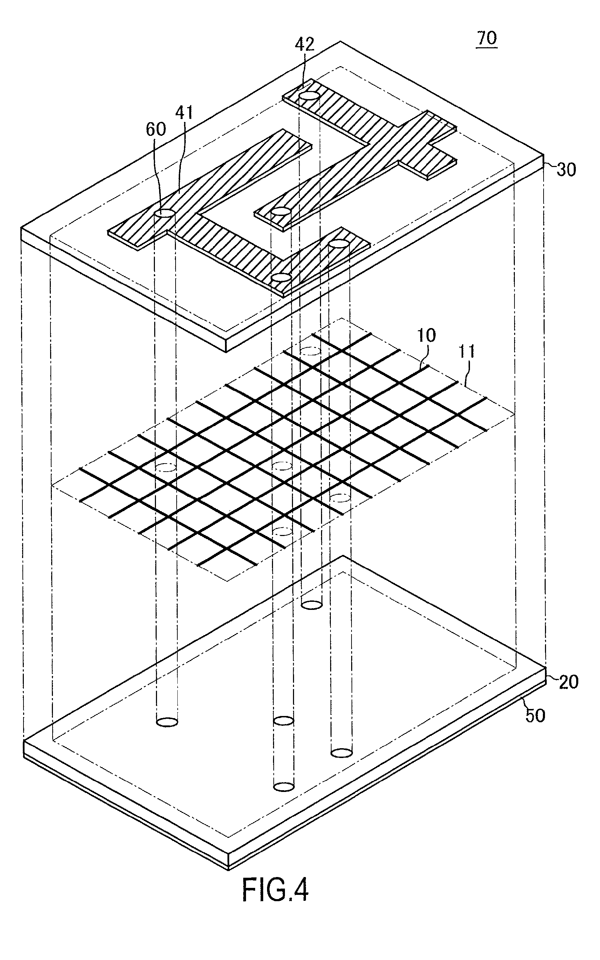

Referring to Figs. 1 to 4, the module component 1 comprises an intermediate layer 70, an upper layer 71, a lower layer 72 and mounted components 74. The intermediate layer 70, which is a substrate constituting the core of the module component, comprises a first layer 20, a second layer 30, a core layer 10, conductive patterns 41, 42 and 50, and through holes 60.

The core layer 10 comprises a material having a higher strength than the first layer 20 and the second layer 30, and has a network structure that extends out in planar fashion. The core layer 10 comprises, for example, a ceramic component and a first thermosetting resin mixed together.

The ceramic component preferably comprises at least one member selected from the group consisting of glass type ceramics, alumina type ceramics and quartz. The first thermosetting resin preferably comprises at least one member selected from the group consisting of epoxy resins, phenol resins, BT resins (Bismaleimide-Triazine reins), polyimide resins andvinylbenzyl resins.

It is preferable to select resin materials for the first layer 20 and the second layer 30 that have high adhesiveness to one another. For example, by using resins of the same composition for both the first layer 20 and the second layer 30, resin materials that have high adhesiveness to one another can be constituted. Alternatively, resins having different composition to one another may be used for the first layer 20 and the second layer 30.

The first layer 20 and the second layer 30 can comprise a resin or a hybrid material, and the hybrid material can be formed by mixing a resin with any one of ceramics, dielectric materials and magnetic materials.

In the case of using resin for the first layer 20 and the second layer 30, the resin preferably comprises at least one member selected from the group consisting of epoxy resins, phenol resins, BT resins, PPE (PolyPhenyleneEther), PPO (PolyPhenyleneOxide), polyimide resins and vinylbenzyl resins.

In the case of using the hybrid material formed by mixing a ceramic component and a resin, the ceramic component preferably comprises at least one member selected from the group consisting of glass type ceramics, alumina type ceramics, forsterite type ceramics, barium titanate type ceramics, BaTiO₃-BaZrO₃ type ceramics, BaO-TiO₂-Nd₂O₃ type ceramics and BaO-4TiO₂ type ceramics, and the resin preferably comprises at least one member selected from the consisting of epoxy resins, phenol resins, BT resins, PPE, PPO, polyimide resins and vinylbenzyl resins.

In this embodiment, a second thermosetting resin is used for the first layer 20 and the second layer 30. This second thermosetting resin is the resin material having a higher thermosetting temperature than the first thermosetting resin. The second thermosetting resin, for example, comprises at least one member selected from the group consisting of epoxy resins, phenol resins, BT resins, polyimide resins and vinylbenzyl resins.

Moreover, the core layer 10 is arranged so that the outer periphery 11 of the core layer 10 is positioned further to the inside than the outer peripheries of the first layer 20 and the second layer 30, and the core layer 10 is sealed between the first layer 20 and the second layer 30.

The conductive patterns 41 and 42 are provided on the main surface of the second layer 30 on the side on which the core layer 10 is not provided. The conductive pattern 50 is provided on the main surface of the first layer 20 on the side on which the core layer 10 is not provided. The conductive patterns 41, 42 and 50 can be made to have any chosen shape. These conductive patterns 41, 42 and 50 constitute passive elements such as capacitors or coils, or wiring patterns.

The through holes 60 are provided in the first layer 20 and the second layer 30, avoiding parts where the core layer 10 is disposed. Each of the through holes 60 is plated (the plating films are not shown in the drawings).

Referring to Fig. 1, the upper layer 71 and the lower layer 72 each comprises a plurality of circuit-forming layers 75 and conductive patterns 73, constituting circuit elements such as capacitors or coils. The circuit-forming layers 75 have an organic component as a principal component, and are laminated to one another. The conductive patterns 73 are provided between the circuit-forming layers 75. The upper layer 71 is laminated on an upper surface of the intermediate layer 70, and the lower layer 72 is laminated on a lower surface of the intermediate layer 70.

Each mounted component 74 is, for example, a passive element such as a resistor, a capacitor or a coil, an active element such as a transistor, or an IC or the like. The mounted components 74 are disposed on the uppermost surface of the upper layer 71. Moreover, the mounted components 74 may also be disposed on the lower layer 72.

In the module component according to the present embodiment, the core layer 10 comprises a material having a higher strength than the first layer 20 and the second layer 30, and extends out in planar fashion. As a result, the strength in the direction orthogonal to the principal plane of the core layer 10 is increased.

Moreover, in the module component according to the present embodiment, the core layer 10 is sealed between the first layer 20 and the second layer 30, and the first layer 20, the second layer 30 and the core layer 10 are integrated into a single body. As a result, the module component according to the present embodiment has increased strength in the direction orthogonal to the principal plane of the core layer 10. The strength required of the intermediate layer of the module component can thus be secured.

In the module component according to the present embodiment, the outer periphery 11 of the core layer 10 is positioned further to the inside than the outer peripheries of the first layer 20 and the second layer 30. As a result, by selecting resin materials for the first layer 20 and the second layer 30 having high adhesiveness to one another, and placing the first layer 20 and the second layer 30 on top of one another with the core layer 10 there between, the core layer 10 can be sealed reliably.

Moreover, the core layer 10 has a network structure, and hence the first layer 20 and the second layer 30 are bonded together via the gaps in the network structure. As a result, by selecting resin materials for the first layer 20 and the second layer 30 having high adhesiveness to one another, the strength of bonding between the first layer 20, the second layer 30 and the core layer 10 can be increased. Moreover, because the core layer 10 has a network structure, it is possible to form through holes avoiding the core layer 10.

Moreover, in the module component according to the present embodiment, the core layer 10 is sealed between the first layer 20 and the second layer 30, and hence is not exposed to the outside. As a result, even if the adhesiveness of the first layer 20 and the second layer 30 to the core layer 10 is low, there will be no absorption of moisture in the air from the interfaces of the core layer 10, and hence degradation of the electrical properties of the circuit elements of the module component can be prevented.

Moreover, in the module component according to the present embodiment, the upper layer 71 is laminated on the upper surface of the intermediate layer 70, and the lower layer 72 is laminated on the lower surface of the intermediate layer 70, and hence the upper layer 71 and the lower layer 72 are integrated into a single body via the intermediate layer 70. As a result, strength can be secured due to the intermediate layer 70, and hence even if the upper layer 71 and the lower layer 72 are not strong, the substrate strength of the module component as a whole can be secured.

Moreover, any chosen material can be used for the upper layer 71 and the lower layer 72, and any chosen circuit elements can be constituted in the upper layer 71 and the lower layer 72.

Moreover, in the module component according to the present embodiment, the mounted components 74 are mounted on any one of the upper layer 71 and the lower layer 72. As a result, circuit elements formed in the intermediate layer 70, the upper layer 71 or the lower layer 72 are integrated with the mounted components 74, and hence functions as a module component 1 can be exhibited.

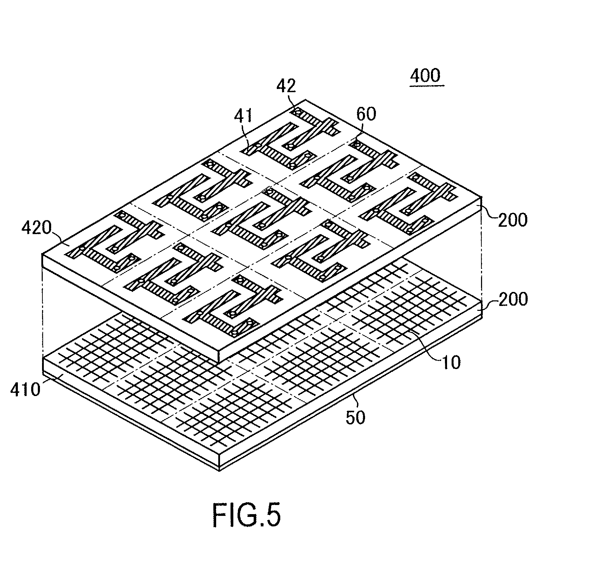

Next, a description will be given of a core substrate element assembly according to the present invention suitable for manufacturing the module component shown in Fig. 1. Referring to Fig. 5, the core substrate element assembly 400 according to the present embodiment comprises a first sheet 410, a second sheet 420, and a group of core layers 10.

The first sheet 410 comprises a second thermosetting resin 200, conductive patterns 50, and through holes 60 (not shown). The second sheet 420 comprises the second thermosetting resin 200, conductive patterns 41 and 42, and through holes 60. The group of core layers 10 comprises a plurality of core layers 10 arranged with prescribed gaps there between.

In this embodiment, the second thermosetting resin is used for the first sheet 410 and the second sheet 420. Alternatively, the same material of which the first layer 20 and the second layer 30 are formed, for example, the hybrid material formed by mixing a resin with any one of ceramics, dielectric material and magnetic material, may be used.

The conductive patterns 50 are provided on the main surface of the second thermosetting resin 200 of the first sheet 410. The conductive patterns 41 and 42 are provided on the main surface of the second thermosetting resin 200 of the second sheet 420.

The group of core layers 10 is disposed between the second thermosetting resin 200 of the first sheet 410 and the second thermosetting resin 200 of the second sheet 420.

The core substrate element assembly 400 according to present embodiment has a constitution in which intermediate layers 70 as shown in Fig. 1 are arranged in a continuous array. As a result, by cutting in the gaps between the core layers 10, for example along the alternate-dot-and-dash lines shown in Fig. 5, the intermediate layers 70 of module components 1 can be manufactured easily.

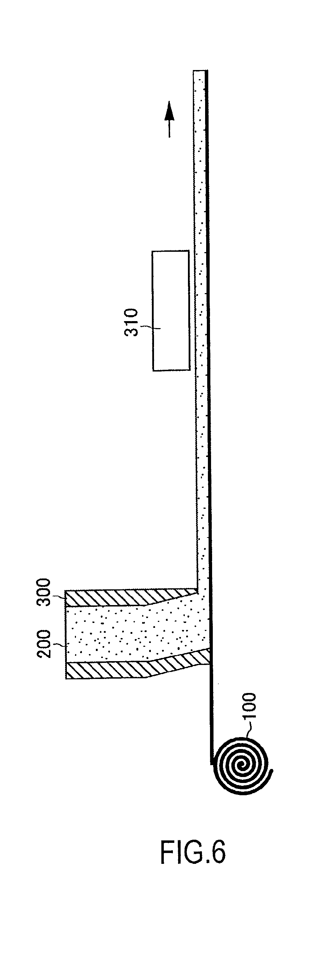

Next, while referring to Figs. 6 to 13, a description will be given of a method of manufacturing the core substrate element assembly according to the present invention In the method of manufacturingthe core substrate element assembly 400 according to the present embodiment, firstly metal foil 100, a core layer material 331 in the form of a slurry, and the second thermosetting resin 200 in the form of a slurry are prepared.

A suitable metal having a good electrical conductivity such as gold, silver, copper or aluminum is used as the metal foil 100. Out of these metals, copper is particularly preferably. Any of various publicly-known methods such as electrolysis or rolling can be used as the method of manufacturing the metal foil 100, but in the case that one wishes to obtain good foil peeling strength, and one attaches importance to the high frequency characteristics of an electrolyzed foil, it is preferable to use a rolled foil for which skin effects due to surface unevenness are small. The core layer material 331 comprises a ceramic component and a first thermosetting resin mixed together.

Next, as shown in Fig. 6, the slurry-form second thermosetting resin 200 is applied onto the metal foil 100, the thickness of the second thermosetting resin 200 is made uniform by using a doctor blade 300, and drying is carried out using a dryer 310.

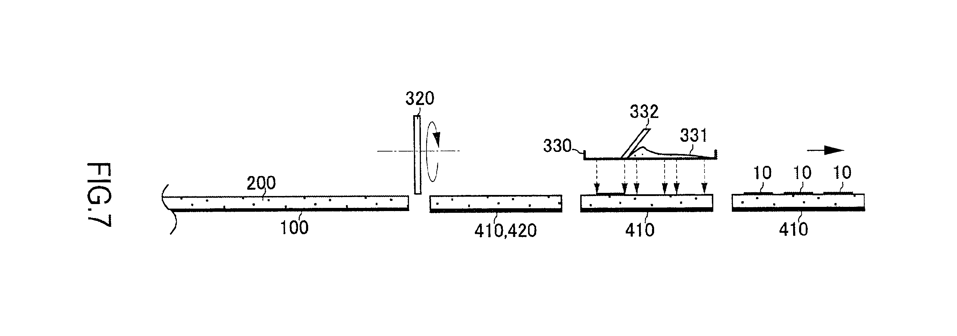

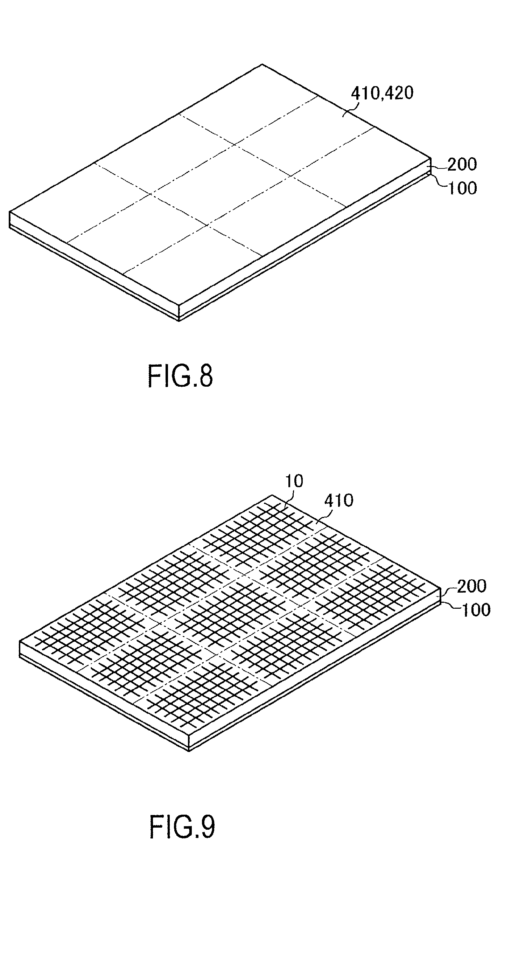

Next, as shown in Figs. 7 and 8, the dried second thermosetting resin 200 and metal foil 100 are cut using a dicer 320, thus forming the first sheet 410 and the second sheet 420. In the present embodiment, the first sheet 410 and the second sheet 420 have the same shape and structure, but sheets having a different shape and structure to one another may be used.

Next, as shown in Figs. 7 and 9, the slurry-form core layer material 331, which has been fed to a screen printing plate 330, is extruded using a squeegee 332, thus printing the core layer material 331 with prescribed gaps, and hence forming the group of core layers 10. After this, the group of core layers 10 and the first sheet 410 are heated and dried, thus hardening the core layers 10.

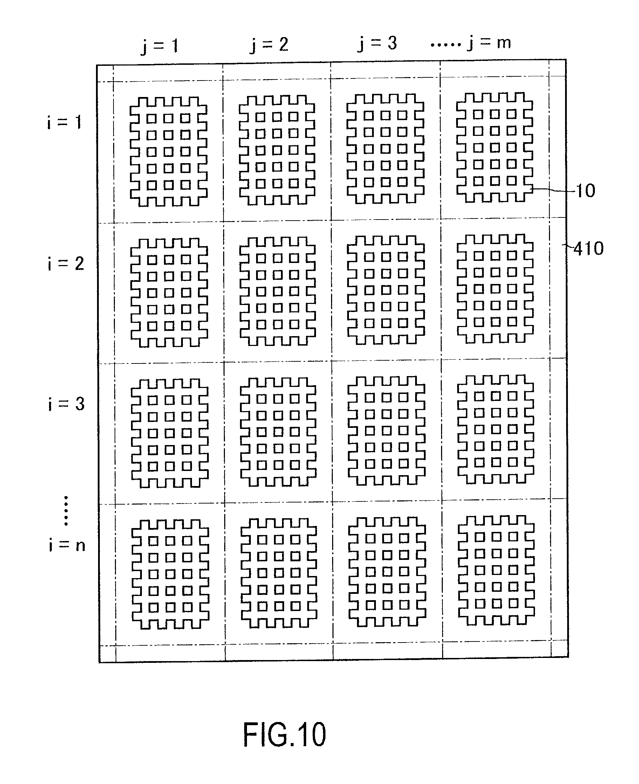

Next, as shown in Fig. 10, the core layers 10 are arranged in an array of for example "n" rows and "m" columns ("n" and "m" are any chosen natural numbers), thus constituting a group.

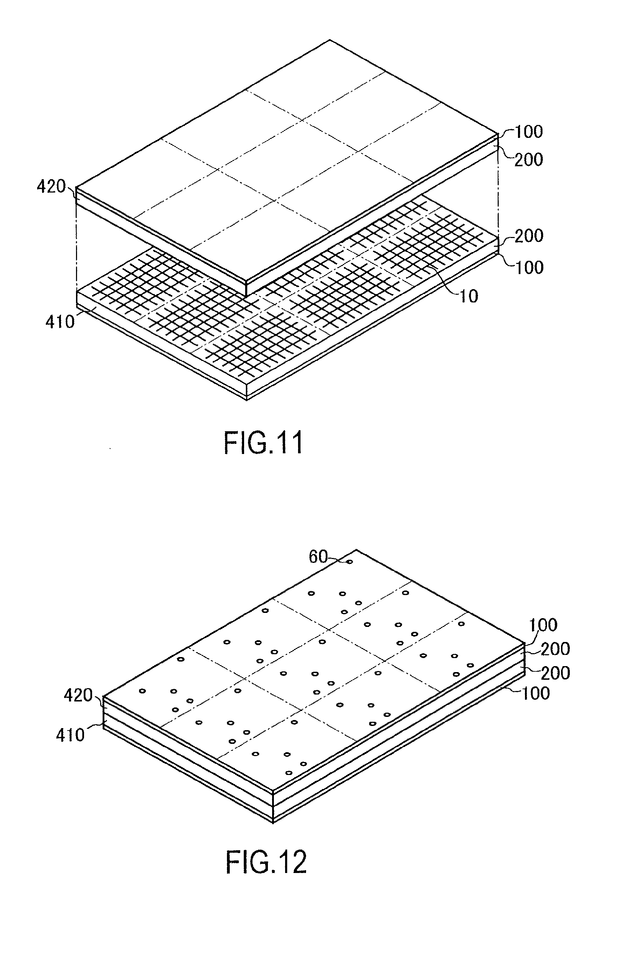

Next, as shown in Fig. 11, the main surface of the second sheet 420 on the side on which the second thermosetting resin 200 has been provided is placed on the main surface of the first sheet 410 on the side on which the core layers 10 have been provided, and pressure and heat are applied. As a result, the two pieces of the second thermosetting resin 200 are bonded together via the core layers 10 and are hardened. The heating temperature is, for example, about 200°C.

Next, as shown in Fig. 12, the through holes 60 are formed through the first sheet 410 and the second sheet 420, avoiding the core layers 10. The through holes 60 formed are then plated (the plating films are not shown).

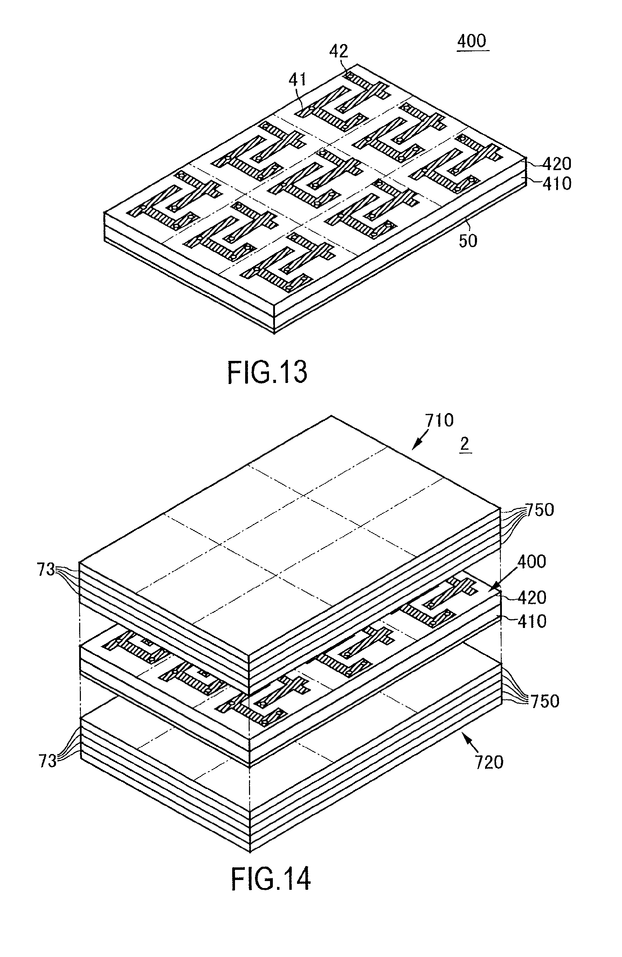

Finally, as shown in Fig. 13, a resist of a prescribed pattern is applied onto the metal foil 100, and etching is carried out, thus forming the conductive patterns 41, 42 and 50.

Moreover, the core substrate element assembly 400 according to the present invention can also be manufactured using a continuous coating method, but detailed description will not be given here.

Next, a description will be given of a multi-layer substrate according to the present invention suitable for manufacturing the module component shown in Fig. 1.

Referring to Fig. 14, the multi-layer substrate 2 according to the present embodiment comprises the core substrate element assembly 400, an upper sheet 710 and a lower sheet 720.

The upper sheet 710 and the lower sheet 720 each comprises a plurality of circuit-forming sheets 750 and conductive patterns 73. The circuit-forming sheets 750 comprise the same material as the circuit-forming layers 75, and are laminated together. The conductive patterns 73 are provided between the circuit-forming sheets 750. The upper sheet 710 is laminated onto the upper surface of the core substrate element assembly 400, and the lower sheet 720 is laminated onto the lower surface of the core substrate element assembly 400.

The multi-layer substrate 2 according to the present embodiment has a structure in which module components 1 as shown in Fig. 1 are arranged in a continuous array. By cutting in the gaps between the core layers 10, for example along the alternate-dot-and-dash lines shown in Fig. 14, module components 1 can thus be manufactured easily.

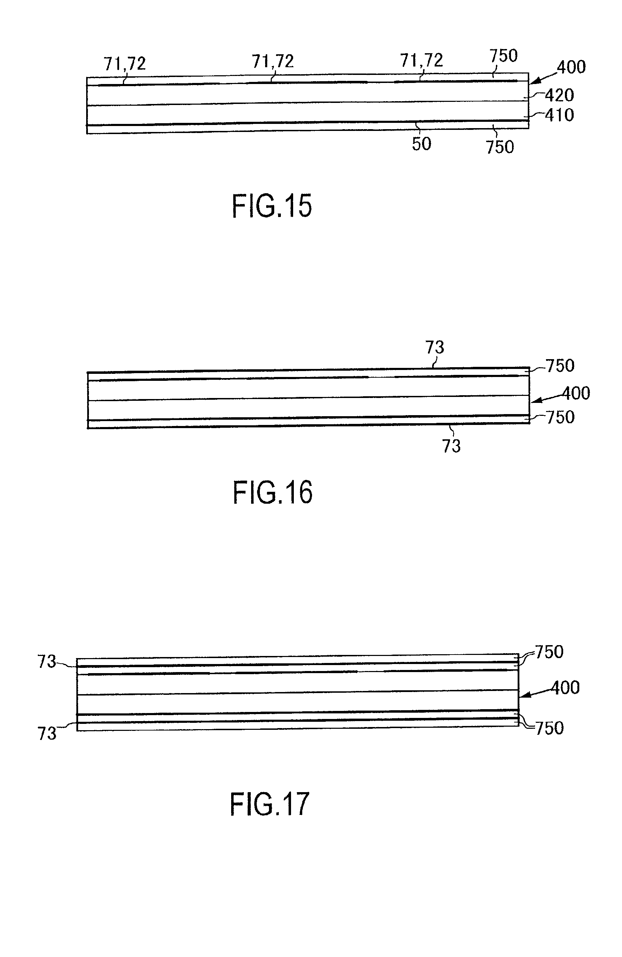

Next, a description will be given of a method of manufacturing the multi-layer substrate according to the present invention. Referring to Figs. 15 to 18, an embodiment of the method of manufacturing the multi-layer substrate according to the present invention is explained. In the method of manufacturingthe multi-layer substrate 2 according to the present embodiment, firstly, as shown in Fig. 15, a circuit-forming sheet 750 is laminated onto each of the upper surface and the lower surface of the core substrate element assembly 400.

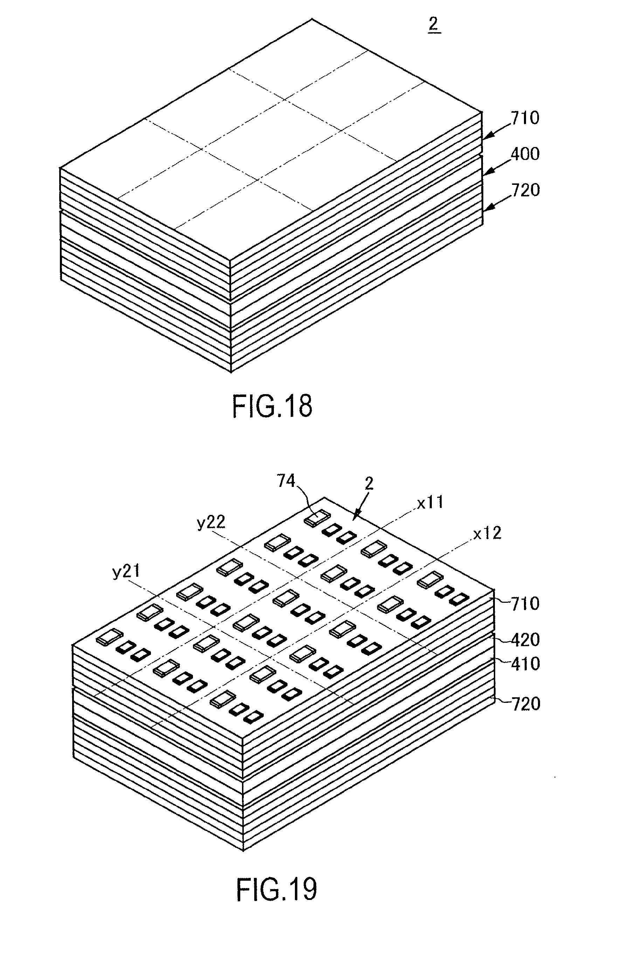

Next, as shown in Fig. 16, conductive patterns 73 are formed on the circuit-forming sheets 750. Next, as shown in Fig. 17, other circuit-forming sheets 750 are laminated onto the circuit-forming sheets 750. By repeating these steps for forming the upper sheet 710 and the lower sheet 720 the required number of times, the multi-layer substrate 2 shown in Fig. 18 can be manufactured.

Finally, while referring to Figs. 19 to 22, a description will be given of a method of manufacturingthe module component according to the present invention.

In the method of manufacturing the module component 1 according to the present embodiment, firstly a multi-layer substrate 2 and mounted components 74 are prepared.

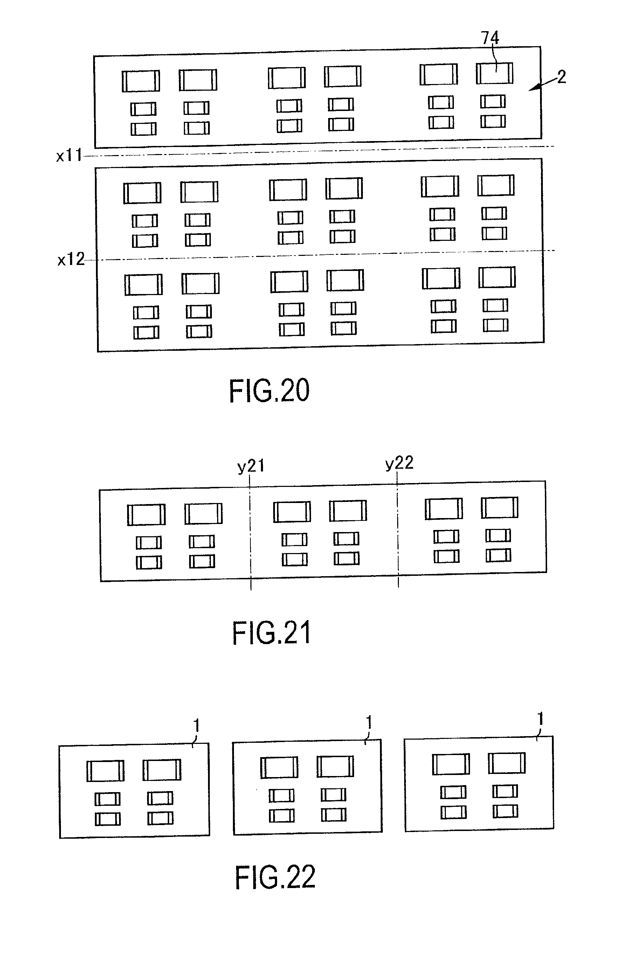

Next, as shown in Fig. 19, the mounted components 74 are mounted on the multi-layer substrate 2. The multi-layer substrate 2 is then cut in the gaps between the core layers 10, for example along the alternate-dot-and-dash lines shown in Fig. 19, thus manufacturing a plurality of module components 1. More specifically, as shown in Figs. 20 to 22, by cutting the multi-layer substrate 2 on which the mounted components 74 have been mounted along x11 and x12 in the transverse direction, and then along y21 and y22 in the longitudinal direction,the module components 1 can be manufactured.

The method of manufacturing the module component 1 according to the present embodiment used the multi-layer substrate 2, and hence module components 1 having the same structure as one another can be mass-produced easily.

As described above, according to the present invention, effects such as the following can be obtained.
(a) A module component having high substrate strength can be provided.
(b) A module component can be provided for which degradation of electrical properties caused by absorption of moisture in the air can be prevented.
(c) A core substrate element assembly suitable for manufacturing a module component as described above can be provided.
(d) A multi-layer substrate suitable for manufacturing a module component as described above can be provided.
(e) A manufacturing method suitable for manufacturing a core substrate element assembly as described above can be provided.
(f) A manufacturing method suitable for manufacturing a multi-layer substrate as described above can be provided.
(g) A manufacturing method suitable for manufacturing a module component as described above can be provided.

## Claims

1. A module component comprising an intermediate layer (70), an upper layer (71), a lower layer (72) and a mounted component (74) **characterized in that**:
the intermediate layer (70) includes a first layer (20), a second layer (30) and a core layer (10);
the core layer (10) comprises a material having a higher strength than the first layer (20) and the second layer (30), has a network structure that extends out in planar fashion, has an outer periphery thereof positioned further to the inside than outer peripheries of the first layer (20) and the second layer (30) and is sealed between the first layer (20) and the second layer (30);
the upper layer (71) is laminated on an upper surface of the intermediate layer (70);
the lower layer (72) is laminated on a lower surface of the intermediate layer (70); and
the mounted component (74) is mounted on any one of theupper layer (71) and the lower layer (72).

2. The module component according to claim 1, wherein the core layer (10) comprises a mixture of a ceramic component and a first thermosetting resin

3. The module component according to claim 2, wherein the ceramic component comprises at least one member selected fromthe group consisting of glass type ceramics, alumina type ceramics and quartz, and the first thermosetting resin comprises at least one member selected from the group consisting of epoxy resins, phenol resins, BT resins, polyimide resins and vinylbenzyl resins.

4. The module component according to claim 1, wherein any one of the first layer (20) and the second layer (30) comprises a resin.

5. The module component according to claim 4, wherein the resin comprises at least one member selected from the group consisting of epoxy resins, phenol resins, BT resins, PPE, PPO, polyimide resins and vinylbenzyl resins.

6. The module component according to claim 2, wherein the first layer (20) and the second layer (30) each comprises a second thermosetting resin, and a thermosetting temperature of the second thermosetting resin is higher than a thermosetting temperature of the first thermosetting resin.

7. The module component according to claim 1, wherein any one of the first layer (20) and the second layer (30) comprises a mixture of a ceramic component and a resin.

8. The module component according to claim 7, wherein the ceramic component comprises at least one member selected fromthe group consisting of glass type ceramics, alumina type ceramics, forsterite type ceramics, barium titanate type ceramics, BaTiO₃-BaZrO₃ type ceramics, BaO-TiO₂-Nd₂O₃ type ceramics and BaO-4TiO₂ type ceramics, and the resin comprises at least one member selected from the group consisting of epoxy resins, phenol resins, BT resins, PPE, PPO, polyimide resins and vinylbenzyl resins.

9. The module component according to claim 1, wherein the intermediate layer (70) comprises a conductive pattern provided on a surface of any one of the first layer (20) and the second layer (30) on a side on which the core layer (10) is not provided.

10. The module component according to claim 1, wherein any one of the upper layer (71) and the lower layer (72) comprises circuit-forming layers (75)and conductive patterns (73), and the circuit-forming layers (75) are laminated together, and the conductive patterns (73) are provided between the circuit-forming layers (75).

11. A core substrate element assembly for manufacturing an intermediate layer of a module component, comprising a first sheet (410), a second sheet (420) and a core layer group **characterized in that**:
the core layer group comprises a plurality of core layers (10) arranged with prescribed gaps therebetween and is disposed between the first sheet (410) and the second sheet (420), and each of the core layers (10) comprises a material having a higher strength than the first sheet (410) and the second sheet (420) and has a network structure that extends out in planar fashion.

12. A method of manufacturing a core substrate element assembly, comprising the steps of:
preparing a first sheet (410), a second sheet (420) and a core layer material (331);
printing the core layer material (331) on the first sheet (410) with prescribed gaps to form a core layer group; and
laminating the second sheet (420) on the first sheet (410) on which the core layer group has been formed.

13. The method of manufacturing a core substrate element assembly according to claim 12, wherein metal foil (100) is provided on a surface of each of the first sheet (410) and the second sheet (420) on a side on which the core layer group is not formed.

14. A multi-layer substrate comprising a core substrate element assembly (400), an upper sheet (710) and a lower sheet (720) **characterized in that**:
the core substrate element assembly (400) includes a first sheet (410), a second sheet (420) and a core layer group, the core layer group comprises a plurality of core layers (10) arranged with prescribed gaps therebetween and is disposed between the first sheet (410) and the second sheet (420), and each of the core layers (10) comprises a material having a higher strength than the first sheet (410) and the second sheet (420) and has a network structure that extends out in planar fashion; and
the upper sheet (710) and the lower sheet (720) each includes circuit-forming sheets (750) and conductive patterns (73), the circuit-forming sheets (750) are laminated together, and the conductive patterns (73) are provided between the circuit-forming sheets (750).

15. A method of manufacturing a multi-layer substrate, comprising the steps of:
preparing a core substrate element assembly (400) and circuit-forming sheets (750), wherein the core substrate element assembly (400) comprises a first sheet (410), a second sheet (420) and a core layer group, and the core layer group includes a plurality of core layers (10) arranged with prescribed gaps therebetween and is disposed between the first sheet (410) and the second sheet (420), and each of the core layers (10) comprises a material having a higher strength than the first sheet (410) and the second sheet (420) and has a network structure that extends out in planar fashion;
laminating one of the circuit-forming sheets (750) on each of an upper surface and a lower surface of the core substrate element assembly (400);
forming a conductive pattern (73) on the circuit-forming sheets (750); and
repeating a required number of times the steps of laminating another circuit-forming sheet (750) on each of the laminated circuit-forming sheets (750) whereby an upper sheet (710) and a lower sheet (720) are formed.

16. A method of manufacturing a module component, comprising the steps of:
preparing a multi-layer substrate (2) and mounted components (74), wherein the multi-layer substrate (2) includes a core substrate element assembly (400) and an upper sheet (710) and a lower sheet (720), and the core substrate element assembly (400) comprises a first sheet (410), a second sheet (420) and a core layer group, and the core layer group comprises a plurality of core layers (10) arranged with prescribed gaps therebetween and is disposed between the first sheet (410) and the second sheet (420), and each of the core layers (10) comprises a material having a higher strength than the first sheet (410) and the second sheet (420) and has a network structure that extends out in planar fashion, and each of the upper sheet (710) and the lower sheet (720) includes circuit-forming sheets (750) and conductive patterns (73), and the circuit-forming sheets (750) are laminated together, and the conductive patterns (73) are provided between the circuit-forming sheets (750);
mounting the mounted components (74) on the multi-layer substrate (2); and
cutting the multi-layer substrate (2) in the gaps between the core layers (10).
